# FASCICULE DE BREVET EUROPEEN

(11) **EP 3 335 239 B1**
(45) Date de publication et mention de la délivrance du brevet: **12.02.2020**
(21) Numéro de dépôt: 16750789.6
(22) Date de dépôt: 08.08.2016
(51) Int. Cl.: H01L 21/762

(54) **PROCÉDÉ DE FABRICATION D'UNE STRUCTURE SEMI-CONDUCTRICE AVEC COLLAGE DIRECT TEMPORAIRE EXPLOITANT UNE COUCHE POREUSE**
VERFAHREN ZUM HERSTELLEN EINER HALBLEITERSTRUKTUR MIT TEMPORÄREM DIREKTBONDEN ANHAND EINER PORÖSEN SCHICHT
METHOD FOR MANUFACTURING A SEMICONDUCTOR STRUCTURE WITH TEMPORARY DIRECT BONDING USING A POROUS LAYER

(30) Priorité: 12.08.2015 FR 1557689
(43) Date de publication de la demande: 20.06.2018
(73) Titulaire: Commissariat à l'Énergie Atomique et aux Énergies Alternatives, 75015 Paris (FR)
(72) Inventeur: BECHE, Elodie, 38000 Grenoble (FR); FOURNEL, Frank, 38190 Villard-Bonnot (FR); LARREY, Vincent, 38140 La Murette (FR)
(74) Mandataire: Brevalex
(86) Numéro de dépôt international: PCT/EP2016/068845
(87) Numéro de publication internationale: WO 2017/025494

(56) Documents cités:
- FR-A1- 3 002 812
- US-A1- 2005 285 290
- US-A1- 2010 123 224
- US-A1- 2012 178 253
- US-B1- 6 417 069

## Description

### DOMAINE TECHNIQUE

Le domaine de l'invention est celui de la réalisation de structures semi-conductrices pour l'électronique, l'optique ou la microélectronique. L'invention porte plus particulièrement sur un procédé de fabrication d'une structure semi-conductrice mettant en œuvre un collage direct temporaire d'un substrat sur un autre.

### ÉTAT DE LA TECHNIQUE ANTÉRIEURE

Au cours d'un procédé de fabrication d'une structure semi-conductrice, des transferts de couches peuvent être mis en œuvre. Si la couche à transférer est d'épaisseur fine (typiquement inférieure à 200 µm), elle ne peut être manipulée par les moyens classiquement utilisés pour manipuler des substrats sous peine de se fissurer, ou plus généralement d'être endommagée lors de son transfert.

Un moyen efficace de pallier à ce risque est de renforcer mécaniquement la couche à transférer par un collage temporaire du substrat comprenant la couche à transférer, dit substrat à manipuler, sur un autre substrat, dit substrat poignée. La couche à transférer peut ainsi être librement manipulée et subir toutes les étapes de fabrication nécessaires à son transfert, et plus généralement à son traitement lors d'étapes FEOL (« Front End Of the Line » désignant l'ensemble des étapes de fabrication des composants actifs d'un circuit intégré).

Le collage temporaire des deux substrats peut être réalisé à l'aide d'une couche adhésive ou bien par collage direct pour former une structure temporaire apte à être soumise à des étapes technologiques de fabrication d'une structure semi-conductrice. Une fois ces étapes réalisées, on procède à la séparation des deux substrats.

Dans le cas d'un collage au moyen d'une couche adhésive, la séparation des deux substrats comprend un démontage de la structure temporaire réalisé mécaniquement et/ou par l'apport d'un budget thermique permettant la transformation de la couche adhésive. Après séparation, une certaine contamination organique demeure sur les substrats, qui peut être enlevée par nettoyage chimique ou par plasma. Cette succession d'étapes permet de ne pas consommer le substrat poignée. Cependant les matériaux adhésifs, type polymères, peuvent se dégrader et devenir instables sous l'effet de contraintes mécaniques ou thermiques appliquées à la structure temporaire. En particulier, il s'avère quasiment impossible de réaliser des étapes technologiques de fabrication de structures semi-conductrices mettant en œuvre des traitements thermiques dépassant 400 °C.

Dans le cas d'un collage direct, celui-ci est communément réalisé par collage direct oxyde-oxyde (natif ou thermique) de substrats de silicium. Un recuit de la structure temporaire résultant du collage est généralement réalisé pour qu'un démontage mécanique soit impossible sans risquer d'endommager la couche mince ou le substrat poignée. La séparation de la couche mince du substrat poignée est alors réalisée par élimination du substrat poignée, par exemple par abrasion mécano-chimique. Ce procédé nécessite alors le sacrifice d'un substrat poignée pour chaque couche mince traitée, ce qui représente un coût non négligeable.

Pour permettre de démonter la structure temporaire, de séparer les deux substrats et rendre possible le recyclage du substrat poignée, des techniques ont été proposées qui consistent à inclure dans l'empilement formant la structure temporaire une ou plusieurs couches pré-fragilisées. Sous l'effet de contraintes mécaniques ou thermiques, ces couches pré-fragilisées sont amenées à se fracturer.

On connait ainsi une technique consistant à pré-fragiliser le substrat à manipuler en créant au sein de celui-ci une couche poreuse enterrée. Sous l'effet d'un apport externe d'énergie mécanique, cette couche poreuse se fracture. Cette technique est par exemple employée dans le procédé ELTRAN® dont on pourra trouver un descriptif dans l'article « Eltran® ; Novel SOI Wafer Technology », JSAP International. 2001, Vol. 4., de T. Yonehara et S. Koyofumi. Du fait de la fracture au sein du substrat à manipuler, cette technique présente l'inconvénient d'engendrer une perte de matériau. Les résidus de la couche poreuse sont par ailleurs difficiles à retirer par gravure sélective car ils sont constitués du même élément chimique que le substrat. Enfin, les surfaces des substrats séparés sont irrégulières et une étape de polissage mécano-chimique CMP (« Chemical-Mechano Polishing ») s'avère nécessaire, ce qui représente un coût non négligeable. Cette étape a en outre la particularité de consommer une partie du substrat.

On connait par ailleurs de la demande de brevet EP 2 977 069 A1 une technique consistant à employer une couche sacrificielle pré-fragilisée à l'interface de collage. Cette couche est pré-fragilisée par implantation ionique et, par un apport thermique, se fracture. Le démontage de la structure intermédiaire s'effectue au niveau de la couche sacrificielle, et non dans l'un des substrats et donc sans perte de matériaux au niveau des substrats. Toutefois, cette technique nécessite elle aussi de réaliser une opération de pré-fragilisation.

FR 3 002 812 A1 décrit un procédé de transfert de couche comprenant : doper une région superficielle d'un substrat de silicium de type p pour former une couche dopée ; rendre poreuse la couche dopée et une couche du substrat de type p sous-jacente à la couche dopée ; former, par croissance épitaxiale, une couche de silicium monocristallin sur la couche poreuse dopée ; et fixer un substrat support à la couche de silicium monocristallin et séparer la couche de silicium monocristallin du substrat de silicium au sein des couches rendues poreuses.

### EXPOSÉ DE L'INVENTION

L'invention concerne un procédé de fabrication d'une structure semi-conductrice mettant en œuvre un collage direct temporaire d'un substrat sur un autre. Elle a pour objectif de fournir un collage qui soit suffisamment résistant pour permettre la réalisation d'étapes technologiques de fabrication de la structure semi-conductrice à haute température (par exemple à 600°C) sans risquer un décollement, et ce au moyen d'un procédé plus simple et moins coûteux que les techniques nécessitant de réaliser une opération de pré-fragilisation d'un substrat ou d'une couche.

A cet effet, l'invention propose un procédé selon la revendication 1 de fabrication d'une structure semi-conductrice.

Certains aspects préférés mais non limitatifs de ce procédé sont définis dans les revendications dépendantes.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- les figures la-ld illustrent un premier mode de réalisation du procédé selon l'invention ;
- les figures 2a-2f illustrent un deuxième mode de réalisation du procédé selon l'invention dans lequel une couche du substrat à manipuler est transférée sur un substrat récepteur;
- les figures 3a-3c illustrent un troisième mode de réalisation du procédé selon l'invention dans lequel le démontage de la structure temporaire conduit à une séparation partielle du substrat poignée ;
- la figure 4 représente la variation de l'énergie de collage en fonction de la température d'un recuit de consolidation appliqué à la structure temporaire.

### EXPOSÉ DÉTAILLÉ DE MODES DE RÉALISATION PARTICULIERS

L'invention a pour objet un procédé de fabrication d'une structure semi-conductrice utilisant un substrat poignée pour supporter un substrat à manipuler.

On entend par structure semi-conductrice n'importe quelle structure qui est utilisée dans la réalisation d'un dispositif à semi-conducteurs. Une structure semi-conductrice peut comprendre des matériaux conducteurs, semi-conducteurs et/ou des matériaux non conducteurs. Il peut s'agir d'une couche comportant ou non des microcomposants, que ce soient des microcomposants finis ou semi finis.

On entend par substrat poignée une structure composite dont la fonction est celle de support mécanique temporaire d'un substrat ou d'une structure. Le substrat poignée est par exemple un substrat de silicium.

On entend par substrat à manipuler un substrat qui est assemblé temporairement à un substrat poignée et sur lequel des traitements peuvent être effectués, en particulier des étapes technologiques FEOL ou BEOL (« Back End Of the Line »). Il peut s'agir par exemple d'un substrat comportant des microcomposants finis ou semi finis à transférer sur un substrat receveur.

Une description du procédé selon l'invention est tout d'abord donnée en référence aux figures la à 1d qui illustrent un premier mode de réalisation.

Au cours d'une première étape représentée sur la figure la, on vient déposer sur le substrat poignée 2 une couche de collage 3 en un matériau poreux.

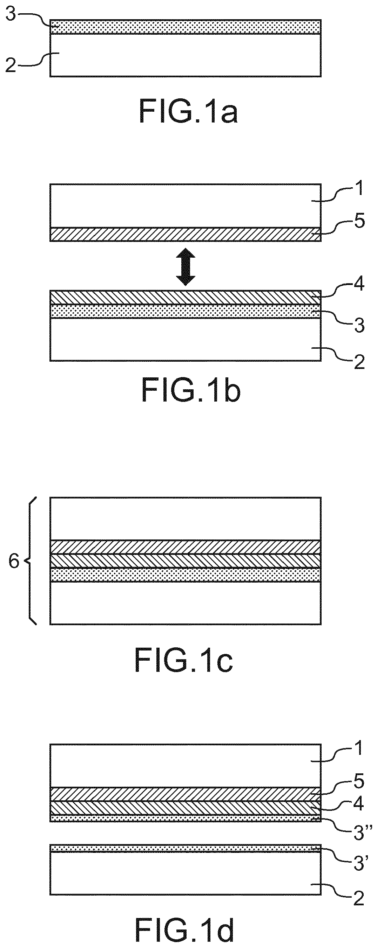

On procède au cours d'une seconde étape illustrée par la figure 1b au collage direct du substrat à manipuler 1 avec le substrat poignée 2 par l'intermédiaire de la couche de collage en un matériau poreux 3 recouvrant le substrat poignée.

Par collage direct, on entend un collage par adhésion moléculaire des surfaces mises en contact, sans utilisation d'un matériau spécifique tel qu'une colle. Le collage direct peut être réalisé à température ambiante et à pression atmosphérique. Il peut être précédé d'un traitement préalable des surfaces à coller, par exemple un traitement chimique visant à les rendre hydrophile ou encore un traitement visant à en réduire la rugosité.

En variante, la couche de collage en matériau poreux peut être déposée sur le substrat à manipuler 1 ou de part et d'autre, à savoir à la fois sur le substrat à manipuler 1 et sur le substrat poignée 2.

Comme représenté sur la figure 1b, la couche de collage 3 peut être recouverte d'une couche additionnelle 4 destinée à faciliter le collage, par exemple sous la forme d'une couche superficielle d'oxyde de silicium. De manière similaire, une couche additionnelle 5 peut venir recouvrir le substrat à manipuler 1.

A l'issue du collage direct (figure 1c), on obtient une structure temporaire 6 formée par l'empilement du substrat à manipuler 1 assemblé au substrat poignée 2 par l'intermédiaire de la couche de collage 3.

Ce collage est suffisamment résistant pour que la structure temporaire 6 puisse être soumise à des étapes technologiques à haute température (par exemple à 600°C), ce qui est impossible lorsque le collage est assuré au moyen de couches polymères ou métalliques. Ces étapes technologiques peuvent notamment comprendre la formation d'au moins une partie d'un composant micro-technologique et/ou la formation d'au moins une couche isolante.

Dans un mode de réalisation possible de l'invention, une étape de renforcement du collage peut être mise en œuvre par apport à la structure temporaire 6 d'un budget thermique dit de renforcement. Ce renforcement du collage peut être obtenu par un recuit d'une durée supérieure à 10 minutes à une température dans la gamme 100°C-600°C.

Ce renforcement est réalisé de manière à permettre la réalisation d'étapes technologiques ultérieures, notamment celles présentant les plus forts budgets thermiques. Le renforcement correspond avantageusement à un premier traitement thermique de la structure intermédiaire, mis en œuvre avant les étapes technologiques ultérieures. Cependant, ces étapes technologiques ultérieures peuvent également participer au budget thermique de renforcement de la tenue mécanique du collage.

En référence à la figure 1d, une fois notamment les différentes étapes technologiques réalisées, on procède au démontage de la structure temporaire 6 au niveau de la couche de collage en matériau poreux 3 pour séparer le substrat à manipuler 1 du substrat poignée 2.

Ce démontage est réalisé par apport d'un budget thermique dit de démontage à la structure intermédiaire 6, ledit apport résultant en un démontage spontané, sans application de contrainte mécanique, de la structure temporaire intervenant au niveau de la couche de collage en matériau poreux 3.

Le démontage peut être réalisé sous atmosphère contrôlée, par exemple pour une couche de collage en matériau organosilicié sous atmosphère d'azote ou une atmosphère mixte N₂ et O₂, afin de maîtriser la réaction entre cette atmosphère et la couche de collage 3 et ainsi mieux contrôler les conditions de démontage (température plus ou moins haute, durée plus ou moins importante, etc.).

L'apport du budget thermique de démontage peut prendre la forme d'un recuit réalisé pendant une durée supérieure à 10 minutes à une température supérieure à 600°C. Dans un mode de réalisation possible, il est possible de réunir le budget thermique de renforcement et le budget thermique de démontage en un seul. Ce budget thermique a alors pour rôle de renforcer la tenue mécanique de la structure intermédiaire puis de démonter cette structure.

Le démontage s'effectue ainsi par fracture au sein de la couche de collage 3 en matériau poreux, et non dans l'un des substrats. Le substrat à manipuler et le substrat poignée ne sont donc pas endommagés.

On retrouve à l'issue de cette fracture d'un côté le substrat poignée 2 recouvert d'une partie 3' issue de la fracture de la couche de collage 3, et de l'autre le substrat à manipuler également recouvert également d'une partie 3" issue la fracture de la couche de collage 3. Il a pu être observé que ces parties 3', 3" peuvent présenter des épaisseurs identiques, la fracture s'exécutant ainsi au milieu de l'épaisseur de la couche de collage 3. Le substrat poignée 2 peut être facilement recyclé en venant procéder à une étape de recyclage comprenant le retrait des résidus 3' de la couche de collage poreuse présents en surface du substrat poignée à l'issue de l'étape de démontage. Cette étape de retrait présente l'avantage de pouvoir être réalisée par gravure sélective, opération moins coûteuse qu'une opération de CMP. Un retrait des résidus 3" présents sur le substrat à manipuler 1 peut être réalisé de manière similaire par gravure sélective. En variante, une opération de CMP peut être réalisée si on souhaite diminuer la rugosité de surface du matériau poreux (sans l'éliminer totalement) et poursuivre le processus de fabrication du substrat à manipuler.

On relèvera que ce procédé est plus simple est moins coûteux que les procédés de l'art antérieur. La démontabilité est en effet obtenue par simple dépôt d'une couche unique, et ne nécessite pas d'opération de pré-fragilisation (mécanique, ou par implantation ionique par exemple) à apporter à l'un des substrats ou à la couche de collage.

La couche de collage en matériau poreux 3 peut être composée d'une matrice inorganique poreuse (métallique, diélectrique, semi-conductrice et plus particulièrement dans les exemples donnés ci-après une matrice comportant des liaisons Si-O) et de composés organiques reliés ou non à la matrice (cycles carbonés, chaines carbonées). Selon l'invention, il s'agit d'une couche poreuse de matériau organosilicié SiOC(H).

Le choix de cette composition permet le démontage spontané de l'assemblage par un double mécanisme. Sous l'effet d'un traitement thermique, le matériau poreux se densifie en périphérie de plaque créant ainsi une zone scellée en bordure de plaque. Les gaz présents dans le matériau poreux sont alors piégés au sein de la structure temporaire 6. L'expansion de ces gaz piégés avec la température conduit à une fracture spontanée au sein de la couche poreuse.

Cette couche de collage en matériau poreux présente également la particularité d'évoluer sous l'effet d'un traitement, par exemple un traitement thermique, chimique ou UV. On peut ainsi par un tel traitement ajuster ou créer (dans le cas d'un dépôt via approche porogène) la porosité de la couche de collage. Cette évolution peut être mécanique (par exemple, densification ou modification de l'état de porosité) ou chimique (par exemple, production ou désorption d'espèces gazeuses).

La couche de collage en matériau poreux 3 peut être déposée par voie physique (exemple : PVD - pour « Physical Vapor Déposition » - et ses dérivées), radicalaire (exemple : sol-gel et ses dérivées), ou encore chimique (exemple : CVD - pour « Chemical Vapor Déposition » - et ses dérivées), et plus particulièrement dans les exemples donnés ci-après par PECVD (« Plasma Enhanced Chemical Vapor Deposition »).

Une couche de collage en un matériau poreux 3 non utilisée par l'invention peut être une couche à porosité auto-générée par l'encombrement stérique de certains groupements tels que des groupements cycliques (exemple de précurseurs matriciels : triméthyltrivinylcyclotétrasiloxane (V3D3) ou tétraméthylcyclotétrasiloxane (TMCTS)), des groupements méthyles ou dérivés carbonés (exemple de précurseurs matriciels: héxaméthyldisiloxane (HMDSO), bistrisméthylsilylméthane (BTMSM), méthylsilane (1MS), diméthylsilane (2MS), triméthylsilane (3MS), bis (trimethylsiloxy)methylsilane (BTMS), méthyltriméthoxysilane (MTMS)).

La couche de collage en un matériau poreux 3 selon l'invention peut être une couche à porosité générée par une approche porogène selon laquelle on introduit lors du dépôt de précurseur matriciel des agents porogènes organiques qui sont ensuite retirés par traitement thermique, UV ou par faisceau d'électrons (« e-beam »).

Les agents porogènes peuvent être chimiquement liés au précurseur matriciel (par exemple : vinyltriméthylsilane (VTMS), divinyldiméthylsilane (DVMS), tétravinylsilane (TVS), diphénylméthylsilane (DPMS)), ou être co-déposés avec le précurseur matriciel (exemples de porogènes : diéthoxyméthylsilane (DEMS), cyclohexène (CHO), décaméthyl-cyclopentasiloxane (DMCPSO), 1-hexène, bicyclohexadiène (BCHD), oxyde de cyclopentène (CPO)).

Dans les exemples de réalisation donnés ci-après, on procède au co-dépôt par PECVD d'un précurseur matriciel de type methyl-Diethoxy-Silane (MDEOS) et d'agents porogènes de type norbornadiène (NBD) sous flux He et O₂. Après retrait des porogènes du co-dépôt, on obtient une couche poreuse à matrice inorganiques Si-O-Si comprenant des groupes méthyles ou dérivés reliés à la matrice par l'atome de silicium (SiO-CH₃).

Le retrait des agents porogènes, réalisé par traitement thermique, UV et/ou e-beam, engendre un taux de porosité variant de 10% à 80% (et plus particulièrement dans les exemples entre 20-30% ±5%) et aussi dans la plupart des cas une contraction d'épaisseur (comprise entre 5% et 25% dans les exemples). Ce retrait peut être réalisé de manière à retirer partiellement ou non les agents porogènes.

Une ou plusieurs étapes ultérieures peuvent être mises en œuvre afin de modifier la couche poreuse déposée, par exemple afin d'en modifier le taux de porosité, la composition chimique et/ou le taux de porogène restant. Ces étapes consistent par exemple en un traitement thermique, UV ou e-beam supplémentaire, en un traitement chimique (par exemple une gravure HF venant élargir le rayon des pores) ou encore en un traitement plasma. On notera que sous traitement thermique, par exemple, les groupes carbonés (restant de porogènes et/ou groupes méthyles) sont susceptibles de se dégrader sous forme de gaz. Ainsi, le procédé selon l'invention peut comprendre suite au dépôt de la couche de collage en matériau poreux une étape de modification du matériau poreux par post traitement thermique, chimique, UV, faisceau d'électrons ou plasma. Il est ainsi possible, par ingénierie du matériau poreux déposé, de modifier certaines de ses propriétés, et ainsi de modifier la température à laquelle se produit le démontage. La composition et les caractéristiques physico-chimiques du matériau poreux sont donc choisies afin d'adapter le budget thermique de renforcement de la tenue mécanique et de démontage de la structure temporaire.

Les gaz utilisés au cours du dépôt de la couche poreuse et les gaz dégagés au cours d'un post-traitement de la couche poreuse déposée peuvent être amenés à être piégés dans la couche de collage, par exemple selon la technique de dépôt employée. Ainsi en venant moduler la quantité de gaz produit, on peut venir contrôler le phénomène de démontage. En effet, c'est l'expansion des gaz piégés du fait de la zone scellée en bordure de plaque qui va entraîner le démontage spontané.

Un exemple de réalisation de l'invention avec deux substrats de silicium (100) de 200 mm dopé P est ci-après détaillé. Le substrat-poignée est recouvert d'une couche de 300 nm de SiO-CH₃ poreux par co-dépôt MDEOS+NBD par PECVD sous He et O₂. Le retrait des agents porogènes est effectué par traitement UV et thermique qui engendre environ 15%±5% de contraction d'épaisseur. La couche déposée a une composition chimique d'environ 15%±5% de Si, 20%±5% de C et de O, 45%±5% de H et une porosité d'environ 20%±10%. La taille des pores, mesurée par ellipsométrie-porosimétrie, est d'environ 1nm±30%. Le substrat à manipuler est un substrat vierge, non recouvert d'un oxyde thermique. Les deux substrats subissent un traitement chimique ayant pour but de rendre hydrophile les surfaces de silicium et de SiO-CH₃ poreux, lequel est réputé pour être très hydrophobe. Ce traitement consiste en un nettoyage chimique de type O₃ + RCA. A l'issue de ces différents traitements, la rugosité de surface est de l'ordre de 5 Â RMS (Root Mean Square) pour la couche poreuse déposée de SiO-CH₃ et de 1.5 Â RMS pour le substrat à manipuler en silicium, ce qui est compatible avec le collage direct hydrophile. Les deux substrats sont alors collés par la méthode de collage direct à température ambiante et pression atmosphérique pour former la structure dite intermédiaire.

Cette structure intermédiaire peut alors subir des traitements thermiques jusqu'à 600°C sans décollement. Puis un recuit à plus haute température, à 900°C pendant 2h en atmosphère mixte O₂+N₂, conduit au démontage de cette structure par fracture au sein de la couche poreuse de SiO-CH₃. La fracture est plus particulièrement exécutée au milieu de la couche poreuse comme le révèle des mesures d'épaisseur par ellipsométrie. L'épaisseur de la couche poreuse transférée sur le substrat à manipuler suite à la fracture est d'environ 100 nm±5% et l'épaisseur de la couche poreuse restante sur le substrat poignée est également d'environ 100 nm±5%. Une zone en bord de plaque, correspondant à la zone scellée, est distinguable à l'œil nu. Son épaisseur est de 118nm±5% sur le substrat à manipuler. Après démontage, une rugosité de 1.8 nm RMS est mesurée dans la partie centrale de chacun des substrats.

Dans un autre exemple de réalisation de l'invention, une découpe de la structure intermédiaire obtenue à l'issue du collage a été réalisée afin d'obtenir des barrettes de collage de largeur 20 mm. Un recuit à 900°C pendant 2h, sous atmosphère mixte O₂ + N₂, de ces barrettes conduit au démontage par facture au sein du matériau poreux de la couche de collage. Sous atmosphère de N₂, le démontage s'opère à 1000°C, soit à une température plus élevée.

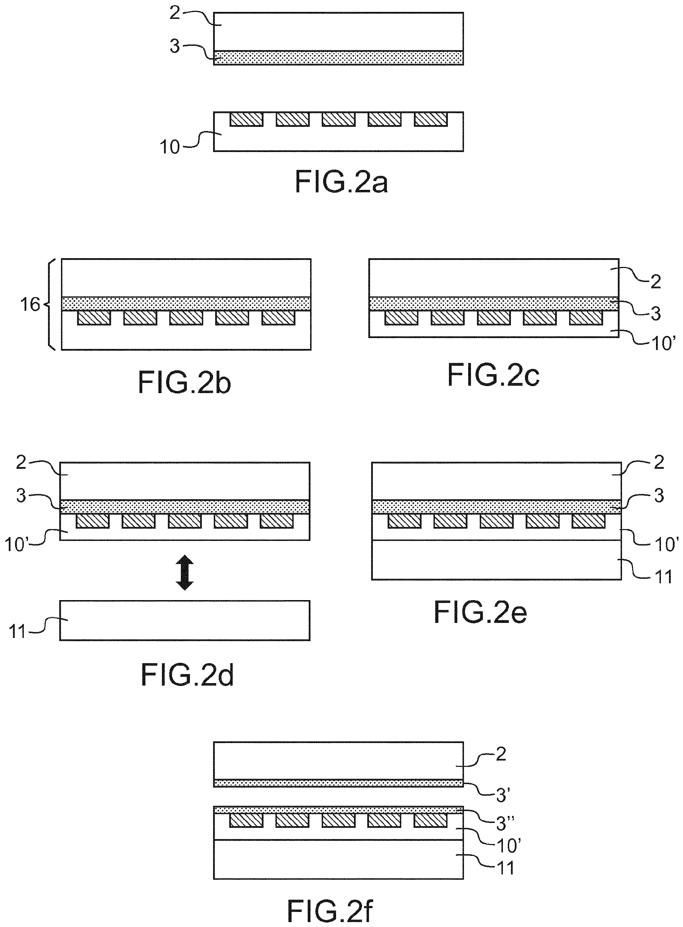

Un autre exemple de réalisation de l'invention est illustré sur les figures 2a-2f. Il met en œuvre, au moyen de deux collages direct, le transfert d'une couche mince 10' du substrat à manipuler 10 vers un substrat receveur 11.

En référence à la figure la, le substrat-poignée 2 est recouvert d'une couche 3 de 300 mm de SiO-CH₃ poreux déposée par PECVD (MDEOS+NBD sous He+O₂). Le retrait des agents porogènes est effectué par traitement UV et thermique qui engendre environ 15%±5% de contraction d'épaisseur. La couche déposée a une composition chimique d'environ 15%±5% de Si, 20%±5% de C et de O, 45%±5% de H et une porosité d'environ 20%±10%.

Le substrat à manipuler 10 est un substrat non fortement dopé qui comprend en surface au moins une partie issue d'étapes FEOL. Les deux substrats 2, 10 sont soumis à un traitement chimique ayant pour but de rendre hydrophile leurs surfaces. Ce traitement consiste en un nettoyage chimique de type O₃ + RCA.

En référence à la figure 2b, les deux substrats sont collés par la méthode de collage direct à température ambiante et pression atmosphérique. Un premier recuit à 400°C durant 2h est appliquer à la structure intermédiaire 16 afin de consolider et de renforcer mécaniquement l'interface de collage.

En référence à la figure 2c, un amincissement du substrat à manipuler est effectué sur sa face arrière libre pour former une couche mince 10'. Cet amincissement peut être réalisé par abrasion mécano-chimique ou par mise en œuvre du procédé Smart Cut™ le substrat à manipuler ayant été précédemment soumis à une implantation ionique.

Puis en référence à la figure 2d, un deuxième collage, hydrophobe, est effectué entre la face arrière libre du substrat à manipuler aminci 10' et un substrat receveur 11. Le substrat receveur est un substrat de silicium dopé non compatible avec l'élaboration de la partie issue d'étapes FEOL présente en surface du substrat à manipuler.

En référence à la figure 2e, un deuxième recuit est effectué sur l'ensemble de l'empilement issu du deuxième collage à 900°C durant 2h. Ce traitement thermique a pour but de consolider l'interface de collage entre la couche mince 10' et le substrat receveur 11 et de séparer le substrat poignée 2 de la couche mince 2' par fracture au sein de la couche poreuse 3. Ce traitement thermique est réalisé à une température suffisamment peu élevée pour ne pas provoquer une diffusion des dopants trop importante.

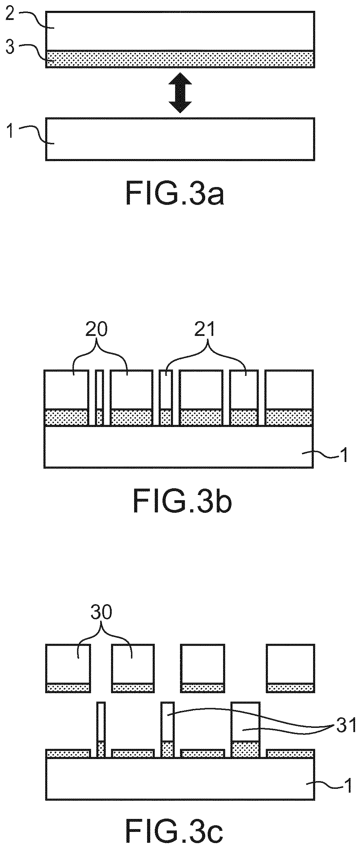

Un autre exemple de réalisation de l'invention est illustré sur les figures 3a-3b. En référence à la figure 3a, on procède au collage direct du substrat à manipuler 1 avec le substrat poignée 2 recouvert de la couche de collage 3 en matériau poreux. En référence à la figure 3b, on procède après collage direct à une étape de découpe du substrat poignée 2 pour y former des tranchées venant isoler des régions 20, du substrat poignée les unes des autres. Des régions de largeur variable (5, 10, 20 et 40mm) ont ainsi été isolées. Des zones scellées vont être créées en bordure de chaque région. Ainsi en référence à la figure 3c, un recuit à 900°C pendant 2h conduit à une séparation partielle du substrat poignée localisée au niveau de régions isolées 20 du substrat poignée, ici les régions présentant une largeur supérieure ou égale à 20mm. Dans les régions de plus petites tailles, la largeur de la zone scellée en bordure de région et la faible quantité de gaz piégé au sein de la région ne permettent pas la séparation spontanée au niveau de cette région.

Cette séparation partielle peut être exploitée pour ne provoquer le démontage que sur une partie centrale de la structure temporaire. Pour ce faire, une tranchée, par exemple annulaire, est réalisée dans le substrat poignée qui vient séparer cette partie centrale d'une partie périphérique du substrat poignée. On obtient alors, éventuellement après un amincissement complémentaire du substrat à manipuler 1, une membrane réalisée dans ce substrat 1 tendue sur la portion périphérique non démontée du substrat poignée, par exemple une portion annulaire.

De façon similaire, une ou plusieurs tranchées peuvent être réalisées dans le substrat à manipuler 1. Il est alors possible d'induire une séparation de ce substrat 1 directement sous forme de puces.

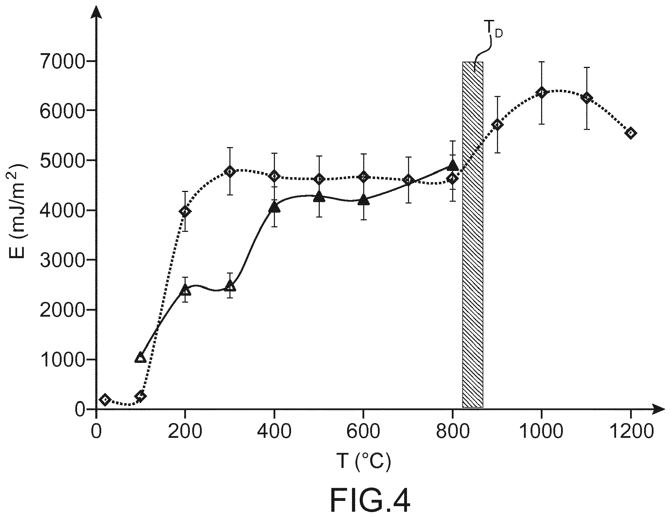

On a représenté sur la figure 4 la variation de l'énergie de collage E, mesurée par la technique d'insertion de lame, en fonction de la température T du recuit de consolidation (ici recuit isotherme pendant deux heures) pour un collage SiO₂/Si (en traits pointillés et mesures identifiées par des losanges) et pour un collage Si de porosité initiale de 20% (en traits pleins et mesures identifiées par des triangles). En dessous de la température de démontage T_{D} (autour de 830 °C), l'énergie de collage E s'avère suffisante pour permettre la réalisation de nombreux procédés technologiques à haute température (dépôt de diélectrique, amincissement par exemple). En outre, cette énergie ne s'effondre pas même à l'approche de la température de démontage.

## Revendications

1. Procédé de fabrication d'une structure semi-conductrice, comprenant les étapes de :
- collage direct d'un substrat à manipuler (1, 10) avec un substrat poignée (2) par l'intermédiaire d'une couche de collage (3) recouvrant le substrat poignée, pour former une structure temporaire (6, 16) apte à être soumise à des étapes technologiques ; et de
- démontage de la structure temporaire au niveau de la couche de collage pour séparer le substrat à manipuler (1, 10) du substrat poignée (2),
où le procédé comprend une étape préalable de dépôt de la couche de collage (3) sur le substrat poignée (2) et/ou sur le substrat à manipuler (1), la couche de collage étant une couche poreuse de matériau organosilicié SiOC(H), et où l'étape de démontage est réalisée par apport d'un budget thermique de démontage à la structure intermédiaire (6, 16), ledit apport résultant en un démontage spontané de la structure temporaire intervenant au niveau de la couche de collage.

2. Procédé selon la revendication 1, dans lequel l'apport du budget thermique de démontage est réalisé sous atmosphère contrôlée, par exemple une atmosphère d'azote ou une atmosphère mixte N₂-O₂.

3. Procédé selon l'une des revendications 1 et 2, dans lequel l'apport du budget thermique de démontage est un recuit réalisé à une température supérieure à 600°C pendant une durée supérieure à 10 minutes.

4. Procédé selon l'une des revendications 1 à 3, comprenant en outre une étape de renforcement du collage mise en œuvre par apport à la structure temporaire (6, 16) d'un budget thermique de renforcement.

5. Procédé selon l'une des revendications 1 à 4, comprenant en outre, avant l'étape de démontage, une étape d'assemblage d'une face arrière libre du substrat à manipuler avec un substrat receveur (11).

6. Procédé selon l'une des revendications 1 à 5, comprenant en outre une étape de recyclage du substrat poignée comprenant le retrait de résidus (3') de la couche de collage présents en surface du substrat poignée (2) à l'issue de l'étape de démontage au moyen d'une gravure sélective.

7. Procédé selon l'une des revendications 1 à 6, dans lequel la couche de collage présente un taux de porosité compris entre 10% et 80%, de préférence entre 15% et 35%.

8. Procédé selon l'une des revendications 1 à 7, dans lequel le dépôt de la couche de collage comprend le dépôt d'un précurseur matriciel sur le substrat poignée et l'introduction d'un agent porogène dans le dépôt du précurseur matriciel.

9. Procédé selon l'une des revendications 1 à 8, comprenant après le dépôt de la couche de collage une étape de modification de la porosité de la couche de collage par post traitement thermique, chimique, UV, faisceau d'électrons ou plasma.

10. Procédé selon l'une des revendications 1 à 9, comprenant, après l'étape de collage direct, la formation d'au moins un tranchée dans le substrat poignée pour isoler des régions (20, 21) du substrat poignée les unes des autres, le démontage de la structure temporaire conduisant à une séparation partielle du substrat poignée localisée au niveau d'au moins une région isolée (20) du substrat poignée.

11. Procédé selon la revendication 10, comprenant la formation d'une tranchée dans le substrat poignée venant séparer une partie centrale du substrat poignée d'une partie périphérique du substrat poignée, le démontage de la structure temporaire conduisant à une séparation partielle du substrat poignée localisée au niveau de la partie centrale du substrat poignée, le substrat à manipuler reposant sur la partie périphérique du substrat poignée.

12. Procédé selon la revendication 11, comprenant un amincissement du substrat à manipuler reposant sur la partie périphérique du substrat poignée.

13. Procédé selon l'une des revendications 1 à 12, comprenant, après l'étape de collage direct, la formation d'une ou plusieurs tranchées dans le substrat à manipuler pour isoler des régions du substrat à manipuler les unes des autres, le démontage de la structure temporaire conduisant à une séparation partielle du substrat à manipuler localisée au niveau d'une ou plusieurs régions isolées du substrat à manipuler.

## Patentansprüche

1. Verfahren zum Herstellen einer Haltleiterstruktur, umfassend die Schritte:
- direktes Bonden eines zu handhabenden Substrats (1, 10) mit einem Griffsubstrat (2) über eine das Griffsubstrat bedeckende Haftschicht (3), um eine Übergangsstruktur (6, 16) zu bilden, die technologischen Schritten unterworfen werden kann; und
- Abbau der Übergangsstruktur im Bereich der Haftschicht, um das zu handhabende Substrat (1, 10) vom Griffsubstrat (2) zu trennen,
wobei das Verfahren einen vorherigen Schritt des Abscheidens der Haftschicht (3) auf das Griffsubstrat (2) und/oder auf das zu handhabende Substrat (1) umfasst, wobei die Haftschicht eine poröse Schicht aus Organosiliziummaterial SiOC(H) ist, und
wobei der Schritt des Abbaus durch Einbringen eines Abbauwärmeeintrags in die Zwischenstruktur (6, 16) erfolgt, wobei das Einbringen zu einem spontanen Abbau der Übergangsstruktur im Bereich der Haftschicht führt.

2. Verfahren nach Anspruch 1, wobei das Einbringen des Abbauwärmeeintrags unter kontrollierter Atmosphäre, beispielsweise unter Stickstoffatmosphäre oder unter N₂-O₂-Mischatmosphäre erfolgt.

3. Verfahren nach einem der Ansprüche 1 und 2, wobei das Einbringen des Abbauwärmeeintrags ein Tempern ist, das bei einer Temperatur von über 600°C über einen Zeitraum von über 10 Minuten erfolgt.

4. Verfahren nach einem der Ansprüche 1 bis 3, ferner umfassend einen Schritt des Verstärkens des Bondens, der durch Einbringen eines Verstärkungswärmeeintrags in die Übergangsstruktur (6, 16) erfolgt.

5. Verfahren nach einem der Ansprüche 1 bis 4, ferner umfassend vor dem Schritt des Abbaus einen Schritt des Zusammenfügens einer freien Rückseite des zu handhabenden Substrats mit einem Empfängersubstrat (11).

6. Verfahren nach einem der Ansprüche 1 bis 5, ferner umfassend einen Schritt des Wiederverwertens des Griffsubstrats, umfassend das Entfernen von Rückständen (3') von der Haftschicht, die nach dem Schritt des Abbaus an der Oberfläche des Griffsubstrats (2) vorhanden sind, durch selektives Ätzen.

7. Verfahren nach einem der Ansprüche 1 bis 6, wobei die Haftschicht einen Porositätsgrad zwischen 10% und 80%, vorzugsweise zwischen 15 % und 35 %, aufweist.

8. Verfahren nach einem der Ansprüche 1 bis 7, wobei die Abscheidung der Haftschicht die Abscheidung eines Matrixvorläufers auf das Griffsubstrat und das Einbringen eines Porenbildners in die Abscheidung des Matrixvorläufers umfasst.

9. Verfahren nach einem der Ansprüche 1 bis 8, umfassend nach der Abscheidung der Haftschicht einen Schritt der Modifizierung der Porosität der Haftschicht durch thermische, chemische, UV-, Elektronenstrahl- oder Plasmanachbehandlung.

10. Verfahren nach einem der Ansprüche 1 bis 9, umfassend nach dem Schritt des direkten Bondens das Bilden von zumindest einem Graben in dem Griffsubstrat, um Bereiche (20, 21) des Griffsubstrats voneinander zu isolieren, wobei der Abbau der Übergangsstruktur zu einer teilweisen Trennung des Griffsubstrats an mindestens einem isolierten Bereich (20) des Griffsubstrats führt.

11. Verfahren nach Anspruch 10, umfassend das Bilden eines Grabens in dem Griffsubstrat, um einen Kernteil des Griffsubstrats von einem Umfangsteil des Griffsubstrats zu trennen, wobei der Abbau der Übergangsstruktur zu einer teilweisen Trennung des Griffsubstrats im Bereich des Kernteils des Griffsubstrats führt, wobei das zu handhabende Substrat auf dem Umfangsteil des Griffsubstrats aufliegt.

12. Verfahren nach Anspruch 11, umfassend ein Verjüngen des zu handhabenden Substrats, das auf dem Umfangsteil des Griffsubstrats aufliegt.

13. Verfahren nach einem der Ansprüche 1 bis 12, umfassend nach dem Schritt des direkten Bondens das Bilden von einem oder mehreren Gräben in dem zu handhabenden Substrat, um Bereiche des zu handhabenden Substrats voneinander zu isolieren, wobei der Abbau der Übergangsstruktur zu einer teilweisen Trennung des zu handhabenden Substrats an einem oder mehreren isolierten Bereichen des zu handhabenden Substrats führt.

## Claims

1. Method for manufacturing a semiconductor structure, comprising the steps of:
- direct bonding of a substrate to be handled (1, 10) with a handle substrate (2) via a bonding layer (3) covering the handle substrate, in order to form a temporary structure (6, 16) capable of withstanding technological steps; and
- disassembly of the temporary structure at the bonding layer in order to separate the substrate to be handled (1, 10) from the handle substrate (2),
wherein the method comprises a prior step of depositing the bonding layer (3) onto the handle substrate (2) and/or onto the substrate to be handled (1), the bonding layer being a porous layer made of organosilicon material SiOC(H), and wherein the disassembly step is carried out by providing a thermal budget for disassembly to the intermediate structure (6, 16), said providing resulting in a spontaneous disassembly of the temporary structure occurring at the bonding layer.

2. Method according to claim 1, wherein providing the thermal budget for disassembly takes place under a controlled atmosphere, for example a nitrogen or mixed N₂-O₂ atmosphere.

3. Method according to either claim 1 or claim 2, wherein providing the thermal budget for disassembly is an annealing process that takes place at a temperature exceeding 600°C for a duration of more than 10 minutes.

4. Method according to one of claims 1 to 3, further comprising a step of strengthening the bonding implemented by providing a thermal budget for reinforcement to the temporary structure (6, 16).

5. Method according to one of claims 1 to 4, further comprising, before the disassembly step, a step of assembling a free rear side of the substrate to be handled with a receiving substrate (11).

6. Method according to one of claims 1 to 5, further comprising a step of recycling the handle substrate comprising the removal of residues (3') of the bonding layer present at the surface of the handle substrate (2) after the disassembly step by selective etching.

7. Method according to one of claims 1 to 6, wherein the bonding layer has a porosity that lies in the range 10% to 80%, preferably in the range 15% to 35%.

8. Method according to one of claims 1 to 7, wherein the deposition of the bonding layer comprises the deposition of a matrix precursor on the handle substrate and the incorporation of a porogenic agent in the deposition of the matrix precursor.

9. Method according to one of claims 1 to 8, comprising, after the deposition of the bonding layer, a step of modifying the porosity of the bonding layer by thermal, chemical, UV, electron beam or plasma post-treatment.

10. Method according to one of claims 1 to 9, comprising, after the direct bonding step, the formation of at least one cut in the handle substrate in order to isolate regions (20, 21) of the handle substrate from each other, the disassembly of the temporary structure resulting in a partial separation of the handle substrate located at at least one isolated region (20) of the handle substrate.

11. Method according to claim 10, comprising the formation of a cut in the handle substrate separating a central portion of the handle substrate from a peripheral portion of the handle substrate, the disassembly of the temporary structure resulting in a partial separation of the handle substrate located at the central portion of the handle substrate, whereby the substrate to be handled rests on the peripheral portion of the handle substrate.

12. Method according to claim 11, comprising a thinning of the substrate to be handled resting on the peripheral portion of the handle substrate.

13. Method according to one of claims 1 to 12, comprising, after the direct bonding step, the formation of one or more cuts in the substrate to be handled in order to isolate regions of the substrate to be handled from each other, the disassembly of the temporary structure resulting in a partial separation of the substrate to be handled located at one or more isolated regions of the substrate to be handled.
